# FASCICULE DE BREVET EUROPEEN

(11) **EP 2 043 419 B1**
(45) Date de publication et mention de la délivrance du brevet: **20.06.2012**
(21) Numéro de dépôt: 08164420.5
(22) Date de dépôt: 16.09.2008
(51) Int. Cl.: H05K 3/34

(54) **Poste d'intervention sur cartes électroniques à ergonomie améliorée**
Interventionsstelle auf elektronischen Karten mit verbesserter Ergonomie
Station for working on electronic boards with improved ergonomics

(30) Priorité: 28.09.2007 FR 0706843
(43) Date de publication de la demande: 01.04.2009
(73) Titulaire: Thales, 92200 Neuilly Sur Seine (FR)
(72) Inventeur: Le Henanff, Pascal, 86100, CHATELLERAULT (FR); Colin, Yves, 86100, CHATELLERAULT (FR)
(74) Mandataire: Nguyen Van Yen, Christian

(56) Documents cités:
- DE-A1- 2 751 856
- FR-A- 2 613 174
- GB-A- 2 063 135
- GB-A- 2 259 039
- US-A- 4 817 851

## Description

La présente invention s'applique aux postes de travail pour des opérateurs ayant à intervenir sur des composants implantés sur des cartes électroniques. Souvent, ces interventions doivent se dérouler dans un environnement où la température des composants est maintenue à un niveau élevé, de l'ordre de 100°C, pendant la durée de l'intervention. En effet, les variations de température en cours d'intervention où un soudage est normalement nécessaire induisent un stress dans les composants qui risque de dégrader leurs performances et fiabilité. Il en résulte à la fois des risques et un inconfort élevé pour les opérateurs pratiquant ces interventions. L'inconfort est aussi lié au fait que les interventions se déroulent généralement sous contrôle par binoculaire et que le dispositif de chauffage généralement utilisé pour maintenir la température des composants va s'intercaler entre le plan de travail et le plan de la binoculaire, ce qui élève le point de pose des yeux de l'opérateurs sur la binoculaire de plus de 10 cm, nécessitant une position debout ou, même interdisant ce type de poste à des opérateurs de taille trop petite.

Bien que se situant dans un contexte différend (absence de binoculaire) le brevet allemand DE 27 51 856 apporte une solution partielle à ce problème en prévoyant un plan de travail dont une partie est inclinée et une évacuation partielle de la chaleur par le dessous du plan de travail.

Cette solution repose cependant principalement sur une hotte aspirante pour l'évacuation des fumées et de la chaleur, ce qui est à la fois difficilement compatible avec l'utilisation d'une binoculaire, encombrant et bruyant.

Le demandeur s'est donc attaché à résoudre ce problème en concevant un nouveau dispositif d'intervention sur carte électronique qui soit à la fois compact et silencieux. A cet effet, le dit dispositif d'intervention comprend un plan de travail, un module de chauffage de ladite carte, ayant une face supérieure sensiblement coplanaire du plan de travail (230) servant de support à la dite carte, un module (310) d'évacuation de la chaleur produite par le module de chauffage par convection et aspiration par la face inférieure du plan de travail vers la partie inférieure du dispositif d'intervention, caractérisé en ce qu'il comprend en outre un module d'aspiration de fumées tubulaire couplé à une optique de visualisation.

Avantageusement, le module de chauffage du dispositif d'intervention sur carte électronique de l'invention utilise un rayonnement infrarouge.

Avantageusement, le dispositif d'intervention sur carte électronique de l'invention comprend en outre un module d'évacuation de la chaleur produite par le module de chauffage par convection et aspiration par la face inférieure du plan de travail vers des servitudes séparées du local du dispositif d'intervention.

Avantageusement, le module d'évacuation de la chaleur du dispositif d'intervention sur carte électronique de l'invention comprend des chicanes de répartition de l'air chaud aspiré.

Avantageusement, le module d'évacuation de la chaleur du dispositif d'intervention sur carte électronique de l'invention qui comprend des chicanes de répartition de l'air chaud aspiré est apte à être mis en dépression.

Avantageusement, le plan de travail du dispositif d'intervention sur carte électronique de l'invention a une forme en « L », le module de chauffage étant positionné sensiblement à l'angle du « L ».

Avantageusement, le dispositif d'intervention sur carte électronique de l'invention comprend en outre un module de contrôle pour limiter l'utilisation aux personnes autorisées.

L'intégration du module de chauffage dans le plan de travail permet de réaliser l'évacuation de la chaleur vers l'extérieur de l'espace de travail et donc d'en préserver l'opérateur. Elle permet également la suppression de l'élévation et donc le travail en position assise.

Ce dispositif présente en outre l'avantage d'autoriser un remplacement facile du module de support. Il est donc plus versatile que les dispositifs de l'art antérieur. L'invention sera mieux comprise et ses différentes caractéristiques et avantages ressortiront de la description qui suit de plusieurs exemples de réalisation et de ses figures annexées dont :
- La figure 1 représente un dispositif de l'art antérieur;
- La figure 2 représente un dispositif selon l'invention;
- La figure 3 représente un module de support et de chauffage à caissons de répartition de chaleur (vue de dessous le plan de travail);
- La figure 4 représente le module d'aspiration de fumées dans un mode de réalisation du dispositif selon l'invention ;
- La figure 5 représente l'agencement du plan et de l'espace de travail dans un mode de réalisation du dispositif selon l'invention.

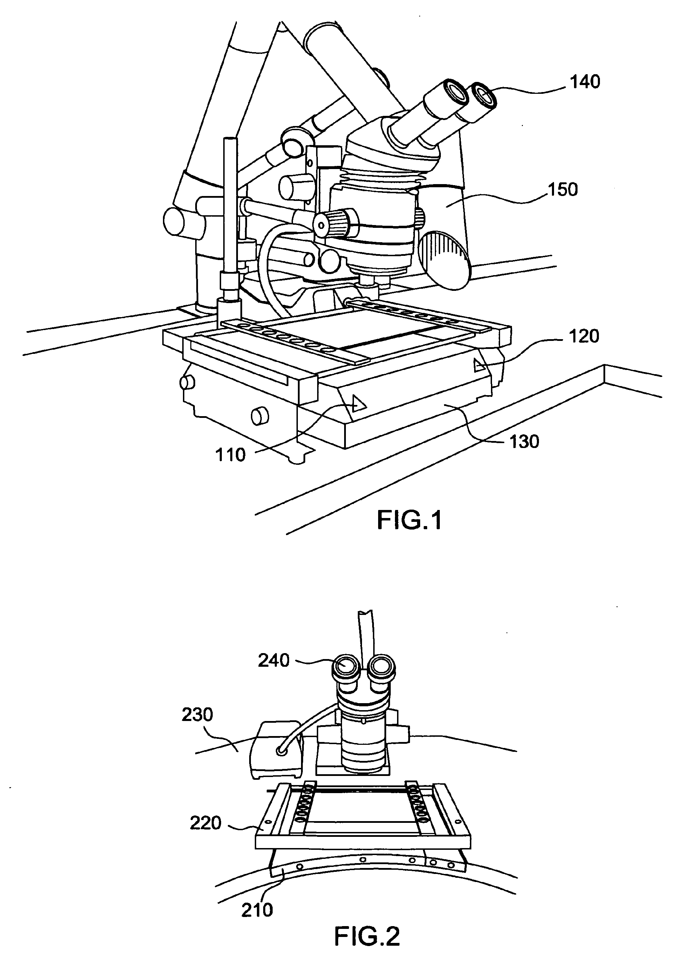

Comme illustré sur la figure 1, un dispositif d'intervention sur cartes électroniques selon l'art antérieur comprend normalement un module de support et de chauffage 110 qui est posé sur un plan de travail 130 et comporte une surface supérieure sur laquelle est posée la carte sur laquelle l'opérateur doit intervenir. L'épaisseur de ce module 110 est généralement de l'ordre de 12 cm. Il comprend une plaque de chauffage dont la température peut atteindre 330°C. Le poste de travail comprend par ailleurs un dispositif binoculaire 140 dont les lunettes sont surélevées de la hauteur du module 110. La chaleur dégagée par la plaque chauffante est dégagée dans l'espace de travail. On adjoint généralement au dispositif une manche à air qui réalise une aspiration des fumées de soudure mais celle-ci ne réduit la chaleur ambiante que de manière très limitée voir nulle.

Comme on le voit sur la figure 2, le dispositif selon l'invention comporte un module de support et de chauffage dont seule la face supérieure 220 est apparente et est sensiblement coplanaire du plan de travail 230. On voit sur la figure que la binoculaire 240 peut être en position sensiblement plus basse que la binoculaire 150 de la figure 1.

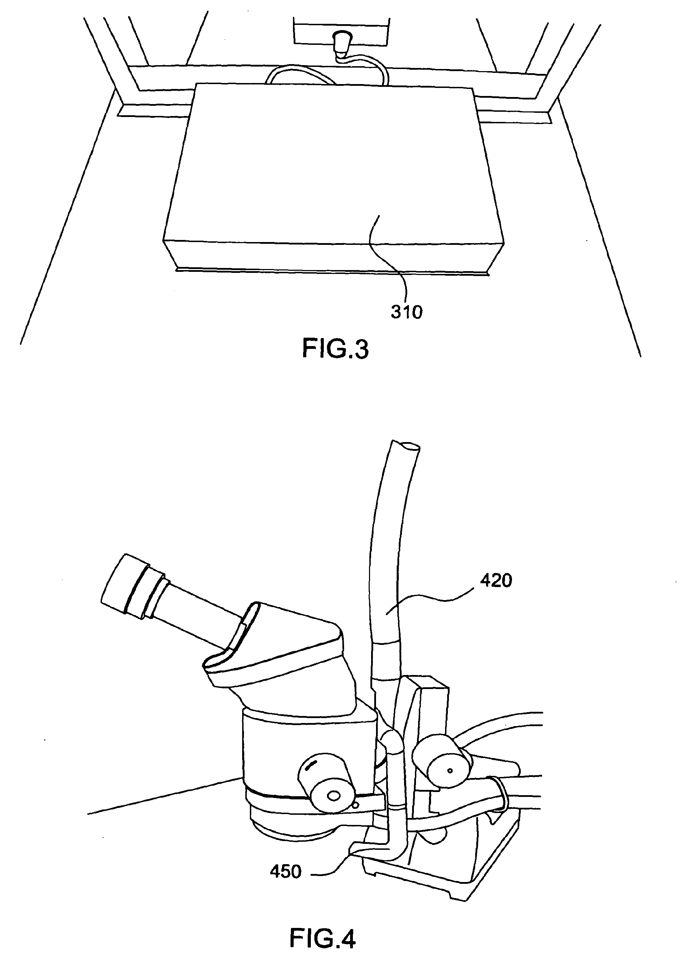

Le module de chauffage lui-même se situe en dessous du plan de travail. Comme illustré sur la figure 3, qui est une vue par le dessous du plan de travail 210, ce module de chauffage peut être avantageusement conditionné dans un bac 310 en acier inoxydable ou dans un autre matériau dissipant la chaleur. Des tuyaux d'aspiration en matière souple sont connectés au bac et conduisent l'air aspiré vers les servitudes situées dans le voisinage immédiat du plan de travail. La dissipation de chaleur dans la partie supérieure du plan de travail est donc grandement réduite. Dans les dispositifs de l'art antérieur, l'élévation de température au voisinage du binoculaire est couramment de 20 à 25°C, soit une température ambiante pouvant facilement atteindre 45 à 50°C. Dans le dispositif selon l'invention, l'élévation de température résiduelle n'est que de 2°C. Ce bac 310 présente en outre l'avantage de préserver l'opérateur des fuites accidentelles de fluide solvant éventuellement enflammé. On prévoira sous la surface du plan de travail 210 des buses d'aspiration de la chaleur. La surface du plan de travail au voisinage de cette surface de support sera avantageusement recouverte d'un matériau thermiquement isolant du type PET. On prévoira en outre avantageusement à l'intérieur du bac 310 des chicanes internes qui réduisent les bruits selon le principe du pot d'échappement automobile. Avantageusement, l'aspiration de l'air chaud sera favorisés par une mise en dépression du bac.

On notera que, dans une variante, le module support peut être remplacé par un interface plein permettant le travail sans utilisation du système de chauffage. Ainsi, le poste peut être utilisé pour des interventions sur cartes qui requièrent l'utilisation d'une binoculaire mais qui ne nécessitent pas le chauffage. Pour cette utilisation, on remplace la surface 220 par une surface différente. Dans ce cas, on prévoira avantageusement un dispositif de sécurité par coupure d'alimentation électrique du chauffage infrarouge lorsque le poste est dans cette configuration sans chauffage (surface supérieure 210 retirée).

Comme on le voit sur la figure 4, le module d'aspiration sur la partie supérieure de l'espace de travail de l'art antérieur 150 est avantageusement remplacé dans un mode de réalisation de l'invention par un module 450 comprenant une ou plusieurs buses de captage des fumées de flux, lesdites fumées étant acheminées également vers l'espace de servitude par des tuyaux souples d'aspiration.

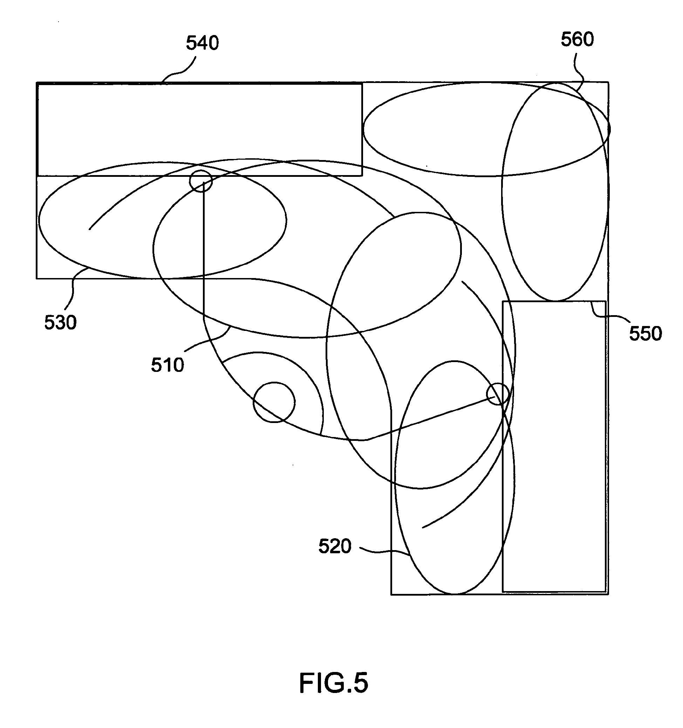

Comme illustré sur la figure 5, on prévoira avantageusement un plan de travail en L, la zone de travail de l'opérateur 510 étant située sensiblement dans la partie intérieure de l'angle du L. Les servitudes, tel l'aspirateur, seront préférentiellement situées dans des zones 550 et 560 (inaccessible). Les modules d'extraction de la chaleur et des fumées doivent être connectées vers des recycleurs périphériques situés dans des locaux techniques En fonction de la qualité de l'ergonomie recherchée, on pourra pré-affecter des zones du plan de travail à certaines utilisations, par exemple une zone 520 à du stockage récurrent (fer à souder notamment), une zone 530 au stockage des consommables (soudure, solvants, etc...), une zone 540 à du stockage aléatoire (gaine, fils...). Bien entendu, ces configurations ne sont citées qu'à titre d'exemple de réalisation. Les postes de par leur conception sont naturellement adaptés aux gauchers et aux droitiers.

Le poste comporte un moyen de mise en fonctionnement par clé mécanique ou électronique, accessible uniquement aux opérateurs habilités. Il faut prévoir également un moyen d'arrêt d'urgence, tel qu'un bouton à presser.

Les exemples de réalisation ci-dessus ne sont bien entendu pas limitatifs et d'autres configurations sont possibles sans sortir du champ de la présente invention.

## Revendications

1. Dispositif d'intervention sur carte électronique comprenant un plan de travail (230), un module de chauffage de ladite carte, ayant une face supérieure (210, 220) sensiblement coplanaire du plan de travail (230) servant de support à la dite carte, un module (310) d'évacuation de la chaleur produite par le module de chauffage par convection et aspiration par la face inférieure du plan de travail (230) vers la partie inférieure du dispositif d'intervention, **caractérisé en ce qu'**il comprend en outre un module d'aspiration de fumées tubulaire (450) mécaniquement lié à une optique de visualisation (240).

2. Dispositif d'intervention sur carte électronique selon la revendication 1 **caractérisé en ce que** module de chauffage utilise un rayonnement infrarouge.

3. Dispositif d'intervention sur carte électronique selon la revendication 1 **caractérisé en ce que** le module d'évacuation de la chaleur (310) comprend des chicanes de répartition de l'air chaud aspiré.

4. Dispositif d'intervention sur carte électronique selon la revendication 3 **caractérisé en ce que** le module d'évacuation de la chaleur (310) est apte à être mis en dépression.

5. Dispositif d'intervention sur carte électronique selon la revendication 4 **caractérisé en ce que** le module d'aspiration des fumées (450) comprend des buses mécaniquement liées à l'optique de visualisation au niveau de l'objectif de ladite optique.

6. Dispositif d'intervention sur carte électronique selon la revendication 1 **caractérisé en ce que** le plan de travail a une forme en « L », le module de chauffage étant positionné sensiblement à l'angle du « L ».

7. Dispositif d'intervention sur carte électronique selon la revendication 1 **caractérisé en ce qu'**il comprend en outre un module de contrôle pour limiter l'utilisation aux personnes autorisées.

## Claims

1. An assembly for working on an electronic board comprising a worktop (230), a module for heating said board, having an upper side (210, 220) substantially coplanar with said worktop (230) acting as a support for said board, a module (310) for dissipating the heat produced by said heating module by convection and suction via the lower side of the worktop (230) to the lower part of the working assembly, **characterised in that** it further comprises a tubular smoke extraction module (450) that is mechanically connected to viewing optics (240).

2. The assembly for working on an electronic board according to claim 1, **characterised in that** the heating module uses infrared radiation.

3. The assembly for working on an electronic board according to claim 1, **characterised in that** the module (310) for dissipating heat comprises baffles for distributing aspirated hot air.

4. The assembly for working on an electronic board according to claim 3, **characterised in that** the module (310) for dissipating heat is adapted for application of a vacuum thereto.

5. The assembly for working on an electronic board according to claim 4, **characterised in that** the smoke extraction module (450) comprises nozzles that are mechanically connected to the viewing optics at the lens of said optics.

6. The assembly for working on an electronic board according to claim 1, **characterised in that** the worktop is "L" shaped, the heating module being positioned substantially at the angle of the "L".

7. The assembly for working on an electronic board according to claim 1, **characterised in that** it further comprises a control module for restricting use to authorised personnel.

## Patentansprüche

1. Anordnung zum Arbeiten an einer Elektronikplatine, die Folgendes umfasst: eine Arbeitsplatte (230), ein Modul zum Erhitzen der Platine, mit einer Oberseite (210, 220), die im Wesentlichen koplanar mit der Arbeitsplatte (230) ist und als Auflage für die Platte dient, ein Modul (310) zum Abführen der von dem Heizmodul erzeugten Wärme durch Konvektion und Saugung durch die Unterseite der Arbeitsplatte (230) zum unteren Teil der Arbeitsanordnung, **dadurch gekennzeichnet, dass** sie ferner ein röhrenförmiges Rauchabzugsmodul (450) aufweist, das mechanisch mit einer Abbildungsoptik (240) verbunden ist.

2. Anordnung zum Arbeiten an einer Elektronikplatine nach Anspruch 1, **dadurch gekennzeichnet, dass** das Heizmodul Infrarotstrahlung benutzt.

3. Anordnung zum Arbeiten an einer Elektronikplatine nach Anspruch 1, **dadurch gekennzeichnet, dass** das Modul (310) zum Abführen von Wärme Ablenkplatten zum Verteilen von abgesaugter Heißluft umfasst.

4. Anordnung zum Arbeiten an einer Elektronikplatine nach Anspruch 3, **dadurch gekennzeichnet, dass** das Modul (310) zum Abführen von Wärme mit Unterdruck beaufschlagt werden kann.

5. Anordnung zum Arbeiten an einer Elektronikplatine nach Anspruch 4, **dadurch gekennzeichnet, dass** das Rauchabzugsmodul (450) Düsen umfasst, die an der Linse der Abbildungsoptik mechanisch mit dieser verbunden sind.

6. Anordnung zum Arbeiten an einer Elektronikplatine nach Anspruch 1, **dadurch gekennzeichnet, dass** die Arbeitsplatte "L"-förmig ist, wobei das Heizmodul im Wesentlichen in dem Winkel von "L" angeordnet ist.

7. Anordnung zum Arbeiten an einer Elektronikplatine nach Anspruch 1, **dadurch gekennzeichnet, dass** sie ferner ein Steuermodul zum Einschränken der Benutzung auf befugtes Personal aufweist.
